(19) Europäisches Patentamt
European Patent Office
Office européen des brevets

(11) EP 2 005 423 B1

(12) EUROPEAN PATENT SPECIFICATION

(45) Date of publication and mention of the grant of the patent:
29.02.2012 Bulletin 2012/09

(21) Application number: 07760327.2

(22) Date of filing: 09.04.2007

(51) Int Cl.:
G10L 19/06 (2006.01)        G10L 19/08 (2006.01)

(86) International application number:
PCT/US2007/066243

(87) International publication number:
WO 2007/121140 (25.10.2007 Gazette 2007/43)

(54) PROCESSING OF EXCITATION IN AUDIO CODING AND DECODING

VERARBEITUNG VON ERREGUNGEN BEI DER AUDIOKODIERUNG UND -DEKODIERUNG

TRAITEMENT DE L'EXCITATION DANS LE CODAGE ET LE DÉCODAGE AUDIO

(84) Designated Contracting States:
AT BE BG CH CY CZ DE DK EE ES FI FR GB GR HU IE IS IT LI LT LU LV MC MT NL PL PT RO SE SI SK TR

(30) Priority: 10.04.2006 US 791042 P
05.04.2007 US 696974

(43) Date of publication of application:
24.12.2008 Bulletin 2008/52

(73) Proprietor: QUALCOMM Incorporated
San Diego, California 92121 (US)

(72) Inventors:
• GARUDADRI, Harinath
San Diego, California 92129 (US)
• SRINIVASAMURTHY, Naveen
San Diego, California 92126 (US)

(74) Representative: Carstens, Dirk Wilhelm
Wagner & Geyer
Gewürzmühlstrasse 5
80538 München (DE)

(56) References cited:
WO-A-2005/096274

• MOTLICEK, HERMANSKY, GARUDADRI, SRINIVASAMURTHY: "Audio Coding Based on Long Temporal Contexts" IDIAP RESEARCH REPORT, [Online] April 2006 (2006-04), XP002423396 Retrieved from the Internet: URL: http://www.idiap.ch/publications/motli cek-idiap-rr-06-30.bib.abs.html> [retrieved on 2007-03-02]
• SCHIMMEL S ET AL: "Coherent Envelope Detection for Modulation Filtering of Speech" ACOUSTICS, SPEECH, AND SIGNAL PROCESSING, 2005. PROCEEDINGS. (ICASSP '05). IEEE INTERNATIONAL CONFERENCE ON PHILADELPHIA, PENNSYLVANIA, USA MARCH 18-23, 2005, PISCATAWAY, NJ, USA,IEEE, 18 March 2005 (2005-03-18), pages 221-224, XP010792014 ISBN: 0-7803-8874-7
• ATHINEOS M ET AL: "Frequency-domain linear prediction for temporal features" AUTOMATIC SPEECH RECOGNITION AND UNDERSTANDING, 2003. ASRU '03. 2003 IEEE WORKSHOP ON ST. THOMAS, VI, USA NOV. 30-DEC. 3, 2003, PISCATAWAY, NJ, USA,IEEE, 30 November 2003 (2003-11-30), pages 261-266, XP010713319 ISBN: 0-7803-7980-2
• HERRE J ET AL: "Enhancing the Performance of Perceptual Audio Coders by Using Temporal Noise Shaping (TNS)" PREPRINTS OF PAPERS PRESENTED AT THE AES CONVENTION, 8 November 1996 (1996-11-08), pages 1-24, XP002102636

**Description**

**Claim of Priority under 35 U.S.C §119**

The present application for patent claims priority to U.S Provisional Application No. 60/791,042, entitled "Processing of Excitation in Audio Coding Based on Spectral Dynamics in Sub-Bands," filed on April 10, 2006, and assigned to the assignee hereof.

**BACKGROUND**

**I. Field**

The present invention generally relates to signal processing, and more particularly, to encoding and decoding of signals for storage and retrieval or for communications.

**II. Background**

In digital telecommunications, signals need to be coded for transmission and decoded for reception. Coding of signals concerns with converting the original signals into a format suitable for propagation over the transmission medium. The objective is to preserve the quality of the original signals but at a low consumption of the medium's bandwidth. Decoding of signals involves the reverse of the coding process.

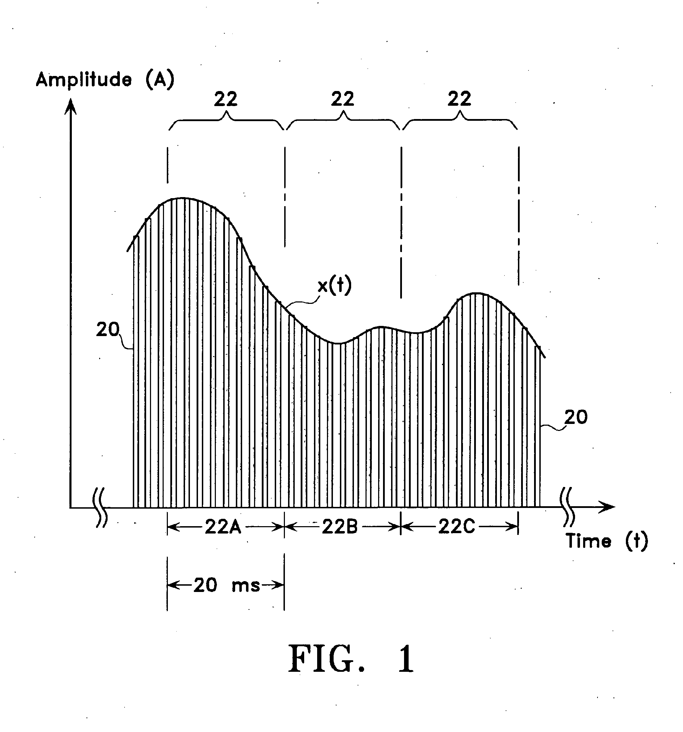

A known coding scheme uses the technique of pulse-code modulation (PCM). Referring to FIG. 1 which shows a time-varying signal x(t) that can be a segment of a speech signal, for instance. The y-axis and the x-axis represent the amplitude and time, respectively. The analog. signal x(t) is sampled by a plurality of pulses 20. Each pulse 20 has an amplitude representing the signal x(t) at a particular time. The amplitude of each of the pulses 20 can thereafter be coded in a digital value for later transmission, for example.

To conserve bandwidth, the digital values of the PCM pulses 20 can be compressed using a logarithmic companding process prior to transmission. At the receiving end, the receiver merely performs the reverse of the coding process mentioned above to recover an approximate version of the original time-varying signal x(t). Apparatuses employing the aforementioned scheme are commonly called the a-law or μ-law codecs.

As the number of users increases, there is a further practical need for bandwidth conservation. For instance, in a wireless communication system, a multiplicity of users can be sharing a finite frequency spectrum. Each user is normally allocated a limited bandwidth among other users.

In the past decade or so, considerable progress has been made in the development of speech coders. A commonly adopted technique employs the method of code excited linear prediction (CELP). Details of CELP methodology can be found in publications, entitled "Digital Processing of Speech Signals," by Rabiner and Schafer, Prentice Hall, ISBN: 0132136031, September 1978; and entitled "Discrete-Time Processing of Speech Signals," by Deller, Proakis and Hansen, Wiley-IEEE Press, ISBN: 0780353862, September 1999. The basic principles underlying the CELP method is briefly described below.

Reference is now returned to FIG. 1. Using the CELP method, instead of digitally coding and transmitting each PCM sample 20 individually, the PCM samples 20 are coded and transmitted in groups. For instance, the PCM pulses 20 of the time-varying signal x(t) in FIG. 1 are first partitioned into a plurality of frames 22. Each frame 22 is of a fixed time duration, for instance 20 ms. The PCM samples 20 within each frame 22 is collectively coded via the CELP scheme and thereafter transmitted. Exemplary frames of the sampled pulses are PCM pulse groups 22A-22C shown in FIG. 1.

For simplicity, take only the three PCM pulse groups 22A-22C for illustration. During encoding prior to transmission, the digital values of the PCM pulse groups 22A-22C are consecutively fed to a linear predictor (LP) module. The resultant output is a set of frequency values, also called a "LP filter" or simply "filter" which basically represents the spectral content of the pulse groups 22A-22C. The LP filter is then quantized.

The LP module generates an approximation of the spectral representation of the PCM pulse groups 22A-22C. As such, during the predicting process, errors or residual values are introduced. The residual values are mapped to a codebook which carries entries of various combinations available for close matching of the coded digital values of the PCM pulse groups 22A-22C. The best fitted values in the codebook are mapped. The mapped values are the values to be transmitted. The overall process is called time-domain linear prediction (TDLP).

Thus, using the CELP method in telecommunications, the encoder (not shown) merely has to generate the LP filters and the mapped codebook values. The transmitter needs only to transmit the LP filters and the mapped codebook values, instead of the individually coded PCM pulse values as in the a- and μ-law encoders mentioned above. Consequently, substantial amount of communication channel bandwidth can be saved.

On the receiver end, it also has a codebook similar to that in the transmitter. The decoder (not shown) in the receiver, relying on the same codebook, merely has to reverse the encoding process as aforementioned. Along with the received LP filters, the time-varying signal x(t) can be recovered.

Heretofore, many of the known speech coding schemes, such as the CELP scheme mentioned above, are based on the assumption that the signals being coded are short-time stationary. That is, the schemes are based on the premise that frequency contents of the coded frames are stationary and can be approximated by simple (all-pole) filters and some input representation in exciting the filters. The various TDLP algorithms in arriving at the codebooks as mentioned above are based on such a model. Nevertheless, voice patterns among individuals can be very different. Non-human audio signals, such as sounds emanated from various musical instruments, are also distinguishably different from that of the human counterparts. Furthermore, in the CELP process as described above, to expedite real-time signal processing, a short time frame is normally chosen. More specifically, as shown in FIG. 1, to reduce algorithmic delays in the mapping of the values of the PCM pulse groups, such as 22A-22C, to the corresponding entries of vectors in the codebook, a short time window 22 is defined, for example 20 ms as shown in FIG. 1. However, derived spectral or formant information from each frame is mostly common and can be shared among other frames. Consequently, the formant information is more or less repetitively sent through the communication channels, in a manner not in the best interest for bandwidth conservation.

Accordingly, there is a need to provide a coding and decoding scheme with improved preservation of signal quality, applicable not only to human speeches but also to a variety of other sounds, and further for efficient utilization of channel resources.

Copending U.S. Patent Application No. 11/583,537, assigned to the same assignee as the current application, addresses the aforementioned need by using a frequency domain linear prediction (FDLP) scheme which first converts a time-varying signal into a frequency-domain signal. The envelope and the carrier portions of the frequency-domain signal are then identified. The frequency-domain signal is then sorted into a plurality of sub-bands. The envelope portion is approximated by the FDLP scheme as an all-pole model. The carrier portion, which also represents the residual of the all-pole model, is approximately estimated. Resulted data of the all-pole model signal envelope and the estimated carrier are packetized as encoded signals suitable for transmission or storage. To reconstruct the time-varying signals, the encoded signals are decoded. The decoding process is basically the reverse of the encoding process.

For improved signal quality, the signal carrier can be more accurately determined prior to packetization and encoding, yet at substantially no extra consumption of additional bandwidth.

Further attention is drawn to the document WO 2005/096274 A which relates to an enhanced audio encoding device, which is consisted of a signal type analyzing module, a psychoacoustical analyzing module, a time-frequency mapping module, a quantization and entropy encoding module, a frequency-domain linear prediction and vector quantization module, and a bit stream multiplexing module, in which the singal type analyzing module is configured to anaylze the signal type of the input audio signal and output to the psychoacoustical analyzing module, the time-frequency mapping module and the bit stream multiplexing module, the frequency-domain linear prediction and vector quantization module is configured to perform a linear prediction of the frequency-domain coefficients and a multi-level vector quantization, and output the residual sequences to the quantization and entropy encoding module while outputting a lateral information to the bit stream multiplexing module.

Furthermore attention is drawn to the document SCHIMMEL S ET AL: "Coherent Envelope Detection for Modulation Filtering of Speech" ACOUSTICS, SPEECH, AND SIGNAL PROCESSING, 2005. PROCEEDINGS. (ICASSP '05). IEEE INTERNATIONAL CONFERENCE ON PHILADELPHIA PENNSYLVANIA, USA MARCH 18-23, 2005, PISCATAWAY, NJ, USA, IEEE, 18 March 2005, pages 221-224, XP010792014, ISBN: 0-7803-8874-7. This document relates to modulation filtering. In particular, past Hilbert envelope approaches generate distortion which spreads across frequency sub-bands and modulation rejection is far from the amount intended. The source of this distortion is analyzed and a solution, based upon coherent envelope detection in each sub-band is proposed. This coherent approach is shown to be substantially more effective than conventional incoherent approaches on speech samples.

SUMMARY

In accordance with the present invention, a method and apparatus for encoding/decoding a time-varying signal, as set forth in claims 1, 5, 8, and 11, are provided. Further embodiments are claimed in the dependent claims.

In an apparatus and method according to claims 1 and 8, a time-varying signal is partitioned into sub-bands. Each sub-band is processed and encoded via a frequency domain linear prediction (FDLP) scheme to arrive at an all-pole model. Residual signal resulted from the scheme in each sub-band is estimated. The all-pole model and the residual signal represent the Hilbert envelope and the Hilbert carrier, respectively, in each sub-band. Through the process of heterodyning, the timedomain residual signal is frequency shifted toward the baseband level as a downshifted carrier signal. Quantized values of the all-pole model and the downshifted carrier signal are packetized as encoded signals suitable for transmission or storage. To reconstruct the time-varying signals, the encoded signals are decoded according to claims 5 and 11. The decoding process is basically the reverse of the encoding process.

The partitioned frames can be chosen to be relatively long in duration resulting in more efficient use of format or common spectral information of the signal source. The apparatus and method implemented as described are suitable for use not only to vocalic voices but also for other sounds, such as sounds emanated from various musical instruments, or combination thereof.

These and other features and advantages will be apparent to those skilled in the art from the following detailed description, taken together with the accompanying drawings, in which like reference numerals refer to like parts.

**BRIEF DESCRIPTION OF THE DRAWINGS**

FIG. 1 shows a graphical representation of a time-varying signal sampled into a discrete signal;

FIG. 2 is a general schematic diagram showing the hardware implementation of the exemplified embodiment of the invention;

FIG. 3 is flowchart illustrating the steps involved in the encoding process of the exemplified embodiment;

FIG. 4 is a graphical representation of a time-varying signal partitioned into a plurality of frames;

FIG. 5 is a graphical representation of a segment of the time-varying signal of FIG. 4;

FIG. 6 is a frequency-transform of the signal shown in FIG. 5;

FIG. 7 is a graphical representation of a sub-band signal of the time-varying signal shown in FIG. 5, the envelope portion of the sub-band signal is also shown;

FIG. 8 is a graphical representation of the carrier portion of the sub-band signal of FIG. 7;

FIG. 9 is a graphical representation of the frequency-domain transform of the sub-band signal of FIG. 7, an estimated all-pole model of the frequency-domain transform is also shown;

FIG. 10 is a graphical representation of the down-shifted frequency-domain transform of FIG. 8;

FIG. 11 is a graphical representation of a plurality of overlapping Gaussian windows for sorting the transformed data for a plurality of sub-bands;

FIG. 12 is a graphical representation showing the frequency-domain linear prediction process;

FIG. 13 is a graphical representation of the reconstructed version of the frequency-domain transform of FIG. 10;

FIG. 14, is a graphical representation of the reconstructed version of the carrier portion signal of FIG. 8;

FIG. 15 is flowchart illustrating the steps involved in the decoding process of the exemplified embodiment;

FIG. 16 is a schematic drawing of a part of the circuitry of an encoder in accordance with the exemplary embodiment; and

FIG. 17 is a schematic drawing of a part of the circuitry of an decoder in accordance with the exemplary embodiment.

**DETAILED DESCRIPTION**

The following description is presented to enable any person skilled in the art to make and use the invention. Details are set forth in the following description for purpose of explanation. It should be appreciate that one of ordinary skill in the art would realize that the invention may be practiced without the use of these specific details. In other instances, well known structures and processes are not elaborated in order not to obscure the description of the invention with unnecessary details. Thus, the present invention is not intended to be limited by the embodiments shown, but is to be accorded with the widest scope consistent with the principles and features disclosed herein.

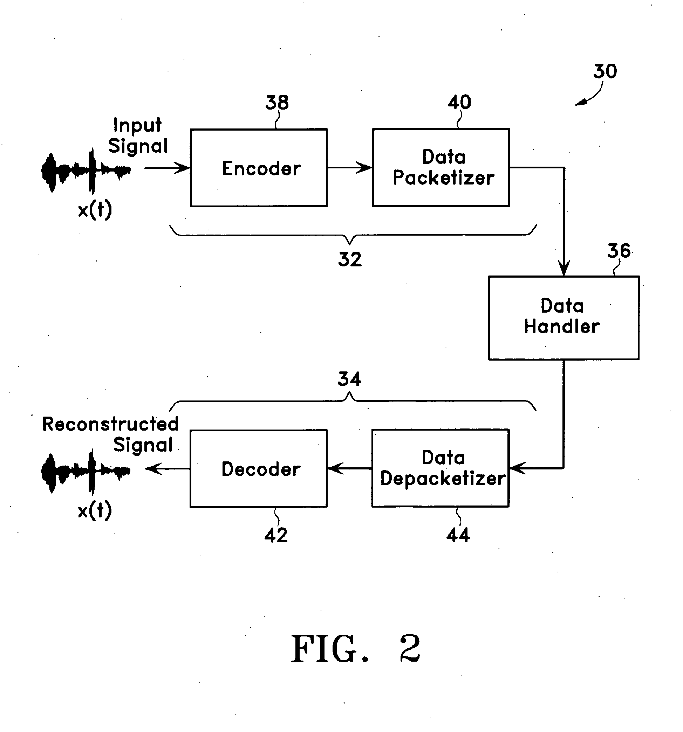

FIG. 2 is a general schematic diagram of hardware for implementing the exemplified embodiment of the invention. The system is overall signified by the reference numeral 30. The system 30 can be approximately divided into an encoding section 32 and a decoding section 34. Disposed between the sections 32 and 34 is a data handler 36. Examples of the data handler 36 can be a data storage device or a communication channel.

In the encoding section 32, there is an encoder 38 connected to a data packetizer 40. A time-varying input signal $x(t)$, after passing through the encoder 38 and the data packetizer 40 are directed to the data handler 36.

In a somewhat similar manner but in the reverse order, in the decoding section 34, there is a decoder 42 tied to a data depacketizer 44. Data from the data handler 36 are fed to the data depacketizer 44 which in turn sends the depacketized data to the decoder 42 for the reconstruction of the original time-varying signal $x(t)$.

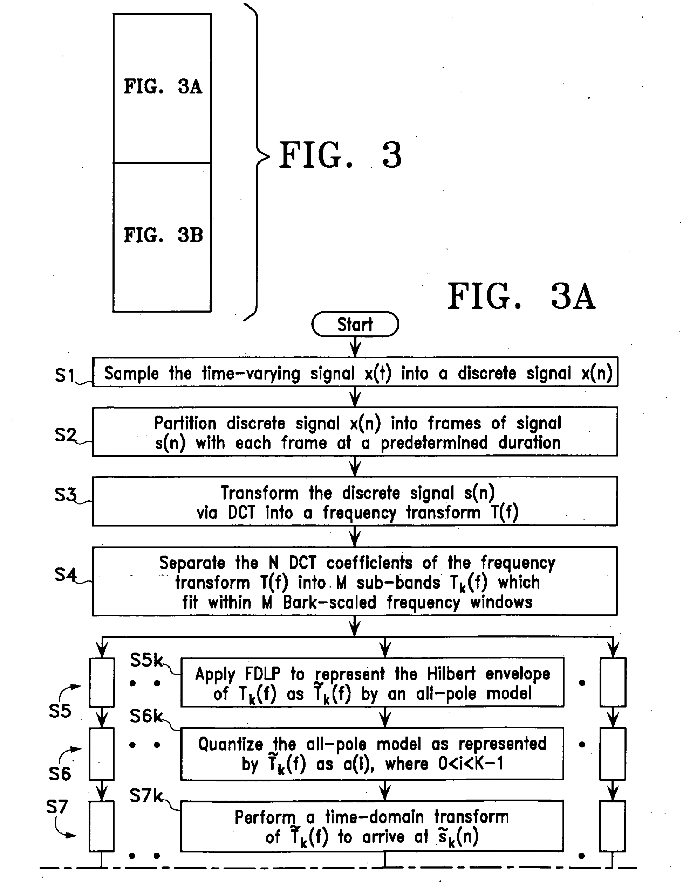

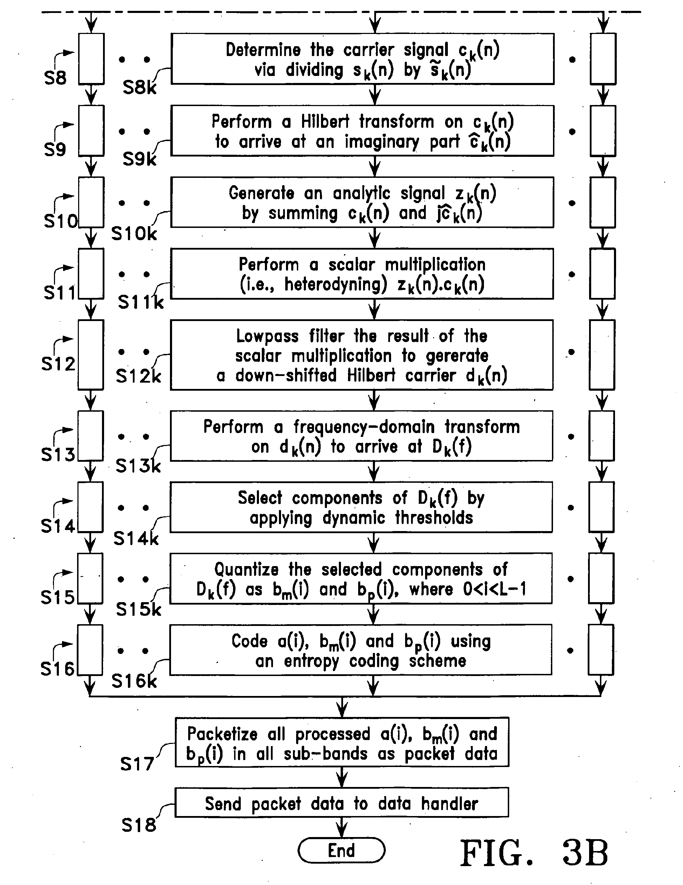

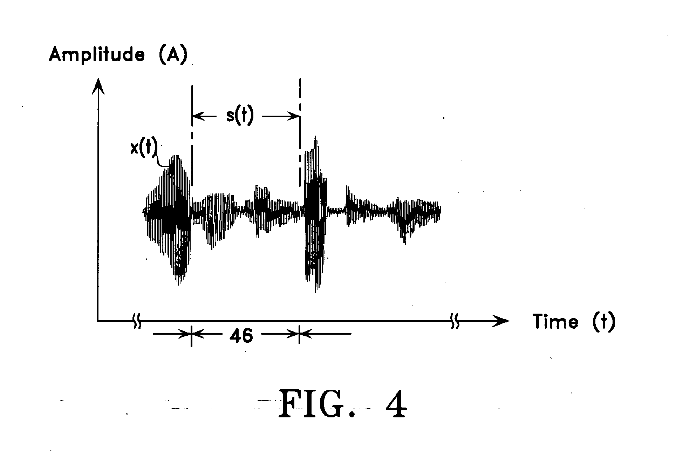

FIG. 3 is a flow diagram illustrating the steps of processing involved in the encoding section 32 of the system 30 shown in FIG. 2. In the following description, FIG. 3 is referred to in conjunction with FIGs. 4-14.

In step S1 of FIG. 3, the time-varying signal $x(t)$ is first sampled, for example, via the process of pulse-code modulation (PCM). The discrete version of the signal $x(t)$ is represented by $x(n)$. In FIG. 4, only the continuous signal $x(t)$ is shown. For the sake of clarity so as not to obscure FIG. 4, the multiplicity of discrete pulses of $x(n)$ are not shown.

In this specification and the appended claims, unless specifically specified wherever appropriate, the term "signal" is broadly construed. Thus the term signal includes continuous and discrete signals, and further frequency-domain and time-domain signals. Moreover, hereinbelow, lower-case symbols denote time-domain signals and upper-case symbols denote frequency-transformed signals. The rest of the notation will be introduced in subsequent description.

Progressing into step S2, the sampled signal x(n) is partitioned into a plurality of frames. One of such frame is signified by the reference numeral 46 as shown in FIG. 4. In the exemplary embodiment, the time duration for the frame 46 is chosen to be 1 second.

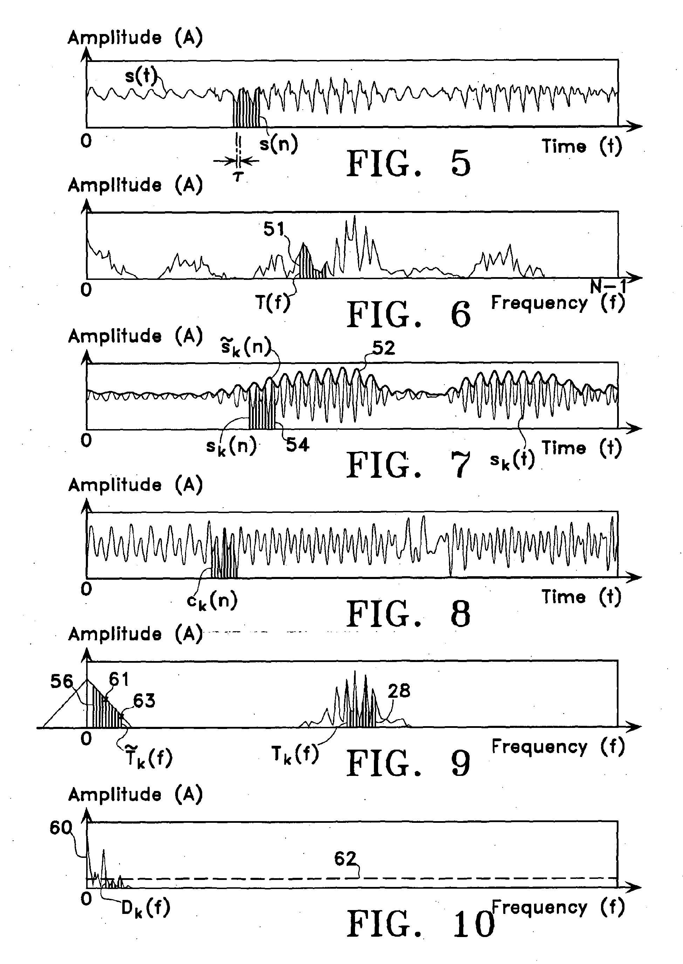

The time-varying signal within the selected frame 46 is labeled s(t) in FIG. 4. The continuous signal s(t) is highlighted and duplicated in FIG. 5. It should be noted that the signal segment s(t) shown in FIG. 5 has a much elongated time scale compared with the same signal segment s(t) as illustrated in FIG. 4. That is, the time scale of the x-axis in FIG. 5 is significantly stretched apart in comparison with the corresponding x-axis scale of FIG. 4. The reverse holds true for the y-axis.

The discrete version of the signal s(t) is represented by s(n), where n is an integer indexing the sample number. Again, for reason of clarity so as not to obscure the drawing figure, only a few samples of s(n) are shown in FIG. 5. The time-continuous signal s(t) is related to the discrete signal s(n) by the following algebraic expression:

$$s(t) = s(n\tau)$$

$$(1)$$

where $\tau$ is the sampling period as shown in FIG. 5.

Progressing into step S3 of FIG. 3, the sampled signal s(n) undergoes a frequency transform. In this embodiment, the method of discrete cosine transform (DCT) is employed. However, other types of transforms, such as various types of orthogonal, non-orthogonal and signal-dependent transforms well-known in the art can be used. Hereinbelow, in this specification and the appended claims, the terms "frequency transform" and "frequency-domain transform" are used interchangeably. Likewise, the terms "time transform" and "time-domain transform" are used interchangeably. Mathematically, the transform of the discrete signal s(n) from the time domain into the frequency domain via the DCT process can be expressed as follows:

$$T(f) = c(f) \sum_{n=0}^{N-1} s(n) \cos \frac{\pi(2n+1)f}{2N}$$

$$(2)$$

where s(n) is as defined above, f is the discrete frequency in which $0 \leq f \leq N$, T is the linear array of the N transformed values of the N pulses of s(n), and the coefficients c are given by $c(0) = \sqrt{1/N}$, $c(f) = \sqrt{2/N}$ for $1 \leq f \leq N - 1$.

After the DCT of the time-domain parameter of s(n), the resultant frequency-domain parameter T(f) is diagrammatically shown in FIG. 6 and is designated by the reference numeral 51. The N pulsed samples of the frequency-domain transform T(f) in this embodiment are called DCT coefficients. Again, only few DCT coefficients are shown in FIG. 6.

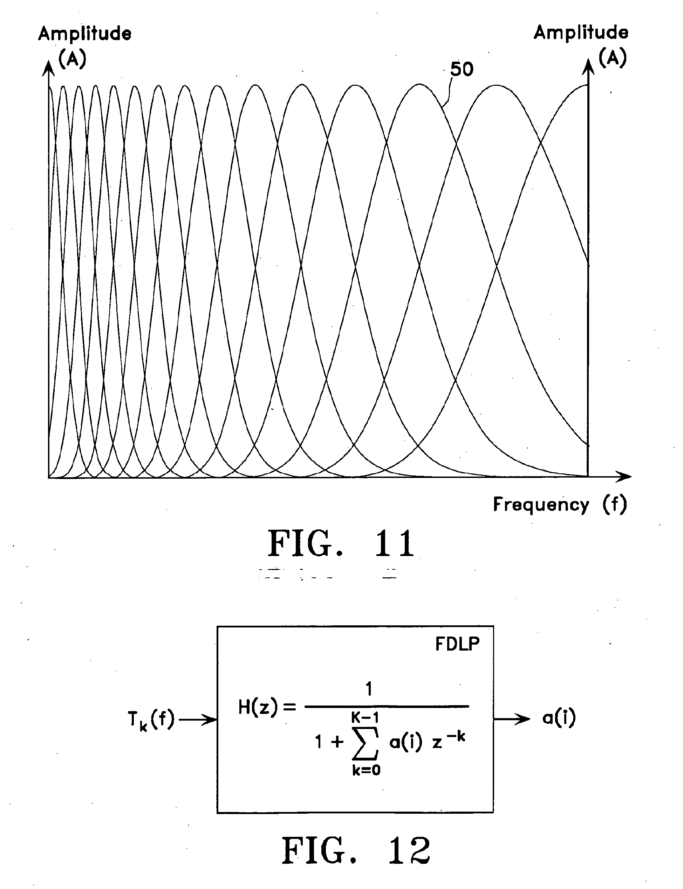

Entering into step S4 of FIG. 3, the N DCT coefficients of the DCT transform T(f) are grouped and thereafter fitted into a plurality of frequency sub-band windows. The relative arrangement of the sub-band windows is shown in FIG. 11. Each sub-band window, such as the sub-band window 50, is represented as a variable-size window. In the exemplary embodiment, Gaussian distributions are employed to represent the sub-bands. As illustrated, the centers of the sub-band windows are not linearly spaced. Rather, the windows are separated according to a Bark scale, that is, a scale implemented according to certain known properties of human perceptions. Specifically, the sub-band windows are narrower at the low-frequency end than at the high-frequency end. Such an arrangement is based on the finding that the sensory physiology of the mammalian auditory system is more attuned to the narrower frequency ranges at the low end than the wider frequency ranges at the high end of the audio frequency spectrum. It should be noted that other approaches of grouping the sub-bands can also be practical. For example, the sub-bands can be of equal bandwidths and equally spaced, instead of being grouped in accordance with the Bark scale as described in this exemplary embodiment.

In selecting the number of sub-bands M, there should be a balance between complexity and signal quality. That is, if a higher quality of the encoded signal is desired, more sub-bands can be chosen but at the expense of more packetized data bits and further a more complex dealing of the residual signal, both will be explained later. On the other hand, fewer numbers of sub-bands may be selected for the sake of simplicity but may result in the encoded signal with relatively lower quality. Furthermore, the number of sub-bands can be chosen as dependent on the sampling frequency. For instance, when the sampling frequency is at 16,000 Hz, M can be selected to be 15. In the exemplary embodiment, the sampling frequency is chosen to be 8,000 Hz and with M set at 13 (i.e., M=13).

After the N DCT coefficients are separated and fitted into the M sub-bands in the form of M overlapping Gaussian windows, as shown in FIG. 11 and as mentioned above, the separated DCT coefficients in each sub-bands need to be further processed. The encoding process now enters into steps S5-S16 of FIG. 3. In this embodiment, each of the steps S5-S16 includes processing M sets of sub-steps in parallel. That is, the processing of the M sets of sub-steps is more or less carried out simultaneously. Hereinbelow, for the sake of clarity and conciseness, only the set involving the sub-steps S5k-S16k for dealing with the $k^{th}$ sub-band is described. It should be noted that processing of other sub-band sets is substantially similar.

In the following description of the embodiment, M=13 and $1 \leq k \leq M$ in which k is an integer. In addition, the DCT coefficients sorted in the $k^{th}$ sub-band is denoted $T_k(f)$, which is a frequency-domain term. The DCT coefficients in the $k^{th}$ sub-band $T_k(f)$ has its time-domain counterpart, which is expressed as $s_k(n)$.

At this juncture, it helps to make a digression to define and distinguish the various frequency-domain and time-domain terms.

The time-domain signal in the $k^{th}$ sub-band $s_k(n)$ can be obtained by an inverse discrete cosine transform (IDCT) of its corresponding frequency counterpart $T_k(f)$. Mathematically, it is expressed as follows:

$$s_k(n) = \sum_{f=0}^{N-1} c(f) T_k(f) \cos \frac{\pi(2n+1)f}{2N}$$

$$(3)$$

where $s_k(n)$ and $T_k(f)$ are as defined above. Again, f is the discrete frequency in which $0 \leq f \leq N$, and the coefficients c are given by $c(0) = \sqrt{1/N}$, $c(f) = \sqrt{2/N}$

for $1 \leq f \leq N - 1$.

Switching the discussion from the frequency domain to the time domain, the time-domain signal in the $k^{th}$ sub-band $s_k(n)$ essentially composes of two parts, namely, the time-domain Hilbert envelope $\tilde{s}_k(n)$ and the Hilbert carrier $c_k(n)$. The time-domain Hilbert envelope $\tilde{s}_k(n)$ is diagrammatically shown in FIG. 7. However, again for reason of clarity, the discrete components of Hilbert envelope $\tilde{s}_k(n)$ is not shown but rather the signal envelope is labeled and as denoted by the reference numeral 52 in FIG. 7. Loosely stated, underneath the Hilbert envelope $\tilde{s}_k(n)$ is the carrier signal which is sometimes called the excitation. Stripping away the Hilbert envelope $\tilde{s}_k(n)$, the carrier signal, or the Hilbert carrier $c_k(n)$, is shown in FIG. 8. Put another way, modulating the Hilbert carrier $c_k(n)$ as shown FIG. 8 with the Hilbert envelope $\tilde{s}_k(n)$ as shown in FIG. 7 will result in the time-domain signal in the $k^{th}$ sub-band $s_k(n)$ as shown in FIG. 7. Algebraically, it can be expressed as follows:

$$s_k(n) = \tilde{s}_k(n) \, c_k(n)$$

$$(4)$$

Thus, from equation (4), if the time-domain Hilbert envelope $\tilde{s}_k(n)$ and the Hilbert carrier $c_k(n)$ are known, the time-domain signal in the $k^{th}$ sub-band $s_k(n)$ can be reconstructed. The reconstructed signal approximates that of a lossless reconstruction.

The diagrammatical relationship between the time-domain signal $s_k(n)$ and its frequency-domain counterpart $T_k(f)$ can also be seen from FIGs. 7 and 9. In FIG. 7, the time-domain signal $s_k(n)$ is shown and is also signified by the reference numeral 54. FIG. 9 illustrates the frequency-domain transform $T_k(f)$ of the time-domain signal $s_k(n)$ of FIG. 7. The parameter $T_k(f)$ is also designated by the reference numeral 28. The frequency-domain transform $T_k(f)$ can be generated from the time-domain signal $s_k(n)$ via the DCT for example, as mentioned earlier.

Returning now to FIG. 3, sub-steps S5k and S6k basically relate to determining the Hilbert envelope $\tilde{s}_k(n)$ and the Hilbert carrier $c_k(n)$ in the sub-band k. Specifically, sub-steps S5k and S6k deal with evaluating the Hilbert envelope $\tilde{s}_k(n)$, and sub-steps S7k-S 16k concern with calculating the Hilbert carrier $c_k(n)$. As described above, once the two parameters $\tilde{s}_k(n)$ and $c_k(n)$ are known, the time-domain signal in the $k^{th}$ sub-band $s_k(n)$ can be reconstructed in accordance with Equation (4).

As also mentioned earlier, the time-domain term Hilbert envelope $\widetilde{s}_k(n)$ in the $k^{th}$ sub-band can be derived from the corresponding frequency-domain parameter $T_k(f)$. However, in sub-step S5k, instead of using the IDCT process for the exact transformation of the parameter $T_k(f)$, the process of frequency-domain linear prediction (FDLP) of the parameter $T_k(f)$ is employed in the exemplary embodiment. Data resulted from the FDLP process can be more streamlined, and consequently more suitable for transmission or storage.

In the following paragraphs, the FDLP process is briefly described followed with a more detailed explanation.

Briefly stated, in the FDLP process, the frequency-domain counterpart of the Hilbert envelope $\widetilde{s}_k(n)$ is estimated, the estimated counterpart is algebraically expressed as $\widetilde{T}_k(f)$ and is shown and labeled 56 in FIG. 9. It should be noted that the parameter $\widetilde{T}_k(f)$ is frequency-shifted toward the baseband since the parameter $\widetilde{T}_k(f)$ is a frequency transform of the Hilbert envelope $\widetilde{s}_k(n)$ which essentially is deprived of any carrier information. However, the signal intended to be encoded is $s_k(n)$ which has carrier information. The exact (i.e., not estimated) frequency-domain counterpart of the parameter $s_k(n)$ is $T_k(f)$ which is also shown in FIG. 9 and is labeled 28. As shown in FIG. 9 and will also be described further below, since the parameter $\widetilde{T}_k(f)$ is an approximation, the difference between the approximated value $\widetilde{T}_k(f)$ and the actual value $T_k(f)$ can also be determined, which difference is expressed as $C_k(f)$. The parameter $C_k(f)$ is called the frequency-domain Hilbert carrier, and is also sometimes called the residual value.

Hereinbelow, further details of the FDLP process and the estimating of the parameter $C_k(f)$ are described.

In the FDLP process, the algorithm of Levinson-Durbin can be employed. Mathematically, the parameters to be estimated by the Levinson-Durbin algorithm can be expressed as follows:

$$H(z) = \frac{1}{1 + \sum_{i=0}^{K-1} a(i)z^{-k}}$$

$$(5)$$

in which H(z) is a transfer function in the z-domain; z is a complex variable in the z-domain; $a(i)$ is the $i^{th}$ coefficient of the all-pole model which approximates the frequency-domain counterpart $\widetilde{T}_k(f)$ of the Hilbert envelope $\widetilde{s}_k(n)$; i = 0, ..., K-1.

Fundamentals of the Z-transform in the z-domain can be found in a publication, entitled "Discrete-Time Signal Processing," 2nd Edition, by Alan V. Oppenheim, Ronald W. Schafer, John R. Buck, Prentice Hall, ISBN: 0137549202, and is not further elaborated in here.

In equation (5), the value of K can be selected based on the length of the frame 46 (FIG. 4). In the exemplary embodiment, K is chosen to be 20 with the time duration of the frame 46 set at 1 sec.

In essence, in the FDLP process as exemplified by Equation (5), the DCT coefficients of the frequency-domain transform in the $k^{th}$ sub-band $T_k(f)$ are processed via the Levinson-Durbin algorithm resulting in a set of coefficients $a(i)$, where $0 \leq i \leq K-1$. The set of coefficients $a(i)$ represents the frequency counterpart $\widetilde{T}_k(f)$ (FIG. 9) of the time-domain Hilbert envelope $\widetilde{s}_k(n)$ (FIG. 7). Diagrammatically, the FDLP process is shown in FIG. 12.

The Levinson-Durbin algorithm is well known in the art and is also not explained in here. The fundamentals of the algorithm can be found in a publication, entitled "Digital Processing of Speech Signals," by Rabiner and Schafer, Prentice Hall, ISBN: 0132136031, September 1978.

Advancing into sub-step S6k of FIG. 3, the resultant coefficients $a(i)$ are quantized. That is, for each value $a(i)$, a close fit is identified from a codebook (not shown) to arrive at an approximate value. The process is called lossy approximation. During quantization, either the entire vector of $a(i)$, where i = 0 to i = K-1, can be quantized, or alternatively, the whole vector can be segmented and quantized separately. Again, the quantization process via codebook mapping is also well known and need not be further elaborated.

The result of the FDLP process is the parameter $\widetilde{T}_k(f)$, which as mentioned above, is the Hilbert envelope $\widetilde{s}_k(n)$ expressed in the frequency-domain term. The parameter $\widetilde{T}_k(f)$ is identified by the reference numeral 56 in FIG. 9. The quantized coefficients $a(i)$ of the parameter $\widetilde{T}_k(f)$ can also be graphically displayed in FIG. 9, wherein two of which are labeled 61 and 63 riding the envelope of the parameter $\widetilde{T}_k(f)$ 56.

The quantized coefficients $a(i)$, where i = 0 to K-1, of the parameter $\widetilde{T}_k(f)$ will be part of the encoded information to be sent to the data handler 36 (FIG. 2).

As mentioned above and repeated in here, since the parameter $\widetilde{T}_k(f)$ is a lossy approximation of the original parameter $T_k(f)$, the difference between the two parameters can be captured and represented as the residual value, which is algebraically expressed as $C_k(f)$. Differently put, in the fitting process in sub-steps S5k and S6k via the Levinson-Durbin algorithm as aforementioned to arrive at the all-pole model, some information about the original signal cannot be captured. If signal encoding of high quality is intended, that is, if a lossless encoding is desired, the residual value $C_k(f)$ needs to be estimated. The residual value $C_k(f)$ basically corresponds to the frequency components of the carrier frequency $c_k(n)$ of the signal $s_k(n)$ and will be further explained.

Progressing into sub-step S7k of FIG. 3, this sub-step concerns with arriving at the Hilbert envelope $\tilde{s}_k(n)$ which can simply be obtained by performing a time-domain transform of its frequency counterpart $\tilde{T}_k(f)$.

Estimation of the residual value either in the frequency-domain expressed as $C_k(f)$ or in the time-domain expressed as $c_k(n)$ is carried out in sub-step S8k of FIG. 3. In this embodiment, the time-domain residual value $c_k(n)$ is simply derived from a direct division of the original time-domain sub-band signal $s_k(n)$ by its Hilbert *envelope* $\tilde{s}_k(n)$. Mathematically, it is expressed as follows:

$$c_k(n) = s_k(n) \, / \, \tilde{s}_k(n)$$

$$(6)$$

where all the parameters are as defined above.

It should be noted that Equation (6) is shown a straightforard way of estimating the residual value. Other approaches can also be used for estimation. For instance, the frequency-domain residual value $C_k(f)$ can very well be generated from the difference between the parameters $T_k(f)$ and $\tilde{T}_k(f)$. Thereafter, the time-domain residual value $c_k(n)$ can be obtained by a direct time-domain transform of the value $C_k(f)$.

In FIG. 3, sub-steps S9k and S11k deal with down-shifting the Hilbert carrier $c_k(n)$ towards the baseband frequency. In particular, sub-steps S9k and S10k concern with generating an analytic signal $z_k(t)$. Frequency down-shifting is carried out via the process of heterodyning in sub-step S11k. Sub-step S12k and S 13k depict a way of selectively selecting values of the down-shifted carrier $C_k(n)$.

Reference is now returned to sub-step S9k of FIG. 3. As is well known in the art, converting a time-domain signal into a complex analytic signal eliminates the negative frequency components in a Fourier transform. Consequently, signal calculation and signal analysis carried out thereafter can be substantially simplified. As in this case, the same treatment is applied to the time-domain residual value $c_k(n)$.

To generate an analytic signal $z_k(n)$ of the time-domain signal $c_k(n)$, a Hilbert transform of the signal $c_k(n)$ needs to be carried out, as shown in step S9k of FIG. 3. The Hilbert transform of the signal $c_k(n)$ is signified by the symbol $\hat{c}_k(n)$ and can be generated from the following algebraic expression:

$$\hat{c}(n) = \frac{1}{\pi} \sum_{n=-\infty}^{\infty} \frac{c_k(\eta)}{n - \eta}$$

$$(7)$$

where all the parameters are as defined above. Equation (7) basically is a commonly known Hilbert transform equation in the time-domain.

After the Hilbert transform, the analytic signal $z_k(n)$ is simply the summation of the time-domain signal $c_k(t)$ and the imaginary part of the Hilbert transform signal $\hat{c}_k(t)$, as shown in step S10k of FIG. 3. Mathematically, it is expressed as follows:

$$z_k(n) = c_k(n) + j\,\hat{c}_k(n)$$

$$(8)$$

where j is an imaginary number

**[0080]** After the derivation of the analytic signal, the process of heterodyning is performed, as shown in sub-step S11k in FIG. 3. In essence, heterodyning is simply a scalar multiplication of the two parameters, that is, the analytic signal $z_k(n)$ and the Hilbert carrier $c_k(n)$. The resultant signal is often called a down-sampled Hilbert carrier $d_k(n)$. As an alternative, the signal $d_k(n)$ can be called a demodulated, down-sampled Hilbert carrier, which basically is a frequency shifted and down-sampled signal of the original Hilbert carrier $c_k(n)$ towards the zero-value or baseband frequency. It should be noted that other terminology for the parameter $d_k(n)$ is also applicable. Such terminology includes demodulated, down-sifted Hilbert carrier, or simply demodulated Hilbert carrier, down-shifted Hilbert carrier, or down-sampled Hilbert carrier. Furthermore, the term "Hilbert" can sometimes be omitted and used instead of the term "Hilbert carrier," it is simply called "carrier." In this specification and appended claims, all these terms as mentioned above are used interchangeably.

Mathematically, the demodulated signal, down-sampled Hilbert carrier, $d_k(n)$ is derived from the following equation:

$$d_k(n) = z_k(Rn)\, c_k(Rn)$$

$$(9)$$

where all the terms are as defined above; R is the down-sampling rate.

By down-shifting the frequency of the parameter $c_k(n)$ to arrive at the parameter $d_k(n)$, processing of the Hilbert carrier in each sub-band, such as filtering and thresholding to be described below, can be substantially made easier. Specifically, the offset frequency of the Hilbert carrier in each sub-band need not be determined or known in advance. For instance, in the implementation of a filter algorithm, all the sub-bands can assume one offset frequency, i.e., the baseband frequency.

After the process of frequency down-shifting, the down-sampled Hilbert carrier $d_k(n)$ is then passed through a low-pass filter, as shown in the sub-step S 12k of FIG. 3.

It should be noted that the demodulated carrier $d_k(n)$ is complex and analytic. As such, the Fourier transform of the parameter $d_k(n)$ is not conjugate-symmetric. Phrased differently, the process of heterodyning the analytic signal $z_k(n)$ essentially shifts the frequency of the Hilbert carrier $c_k(n)$ as $d_k(n)$ towards the baseband frequency, but without the conjugate-symmetric terms in the negative frequency. As can be seen from the frequency-domain transform $D_k(f)$ of the down-shifted carrier $d_k(n)$ in FIG. 10, in which the parameter $D_k(f)$ is shifted close to the origin denoted by the reference numeral 60. The process of frequency transforming the downshifted carrier $d_k(n)$ into the frequency domain counterpart $D_k(f)$ is depicted in step S13k of FIG. 3.

Entering into step S 14k of FIG. 3, the frequency-domain transform $D_k(f)$ of the demodulated Hilbert carrier $d_k(n)$ is subject to threshold filtering. An exemplary threshold line signified by the reference numeral 62 is as shown in FIG. 10.

In this exemplary embodiment, the threshold is dynamically applied. That is, for each sub-band, the threshold 62 is made adjustable based on other parameters, such as the average and maximum magnitudes of the samples of the parameter $D_k(f)$, and/or the same parameters but of the neighboring sub-bands of the parameter $D_k(f)$. In addition, the parameters can also include the average and maximum magnitudes of the samples of the parameter $D_k(f)$, and/or the same parameters but of the adjacent time-frames of the parameter $D_k(f)$. Furthermore, the threshold can also be dynamically adapted based on the number of coefficients selected. In the exemplary embodiment, only values of the frequency-domain transform $D_k(f)$ above the threshold line 62 are selected.

Thereafter, selected components of the parameter $D_k(f)$ greater than the threshold are quantized. In this example, each selected component includes a magnitude value $b_m(i)$ and a phase value $b_p(i)$, where $0 \le i \le L-1$. The quantized values $b_m(i)$ and bp(i) are represented as the quantized values as shown in sub-step S15k in FIG. 3.

The quantized values $b_m(i)$ and bp(i), where i = 0 to L-1, of the threshold-filtered parameter $D_k(f)$ will be another part of the encoded information along with the quantized coefficients a(i), where i = 0 to K-1, as described above to be sent to the data handler 36 (FIG. 2).

Reference is now returned to FIG. 3. After the Hilbert envelope $\tilde{s}_k(n)$ and the Hilbert carrier $c_k(n)$ information are acquired from the $k^{th}$ sub-band represented as coefficients a(i), $b_m(i)$ and bp(i) as described above, the acquired information is coded via an entropy coding scheme as shown in step S16k.

Thereafter, all the data from each of the M sub-bands are concatenated and packetized, as shown in step S17 of FIG. 3. As needed, various algorithms well known in the art, including data compression and encryption, can be implemented in the packetization process. Afterward, the packetized data can be sent to the data handler 36 (FIG. 2) as shown in step S18 of FIG. 3.

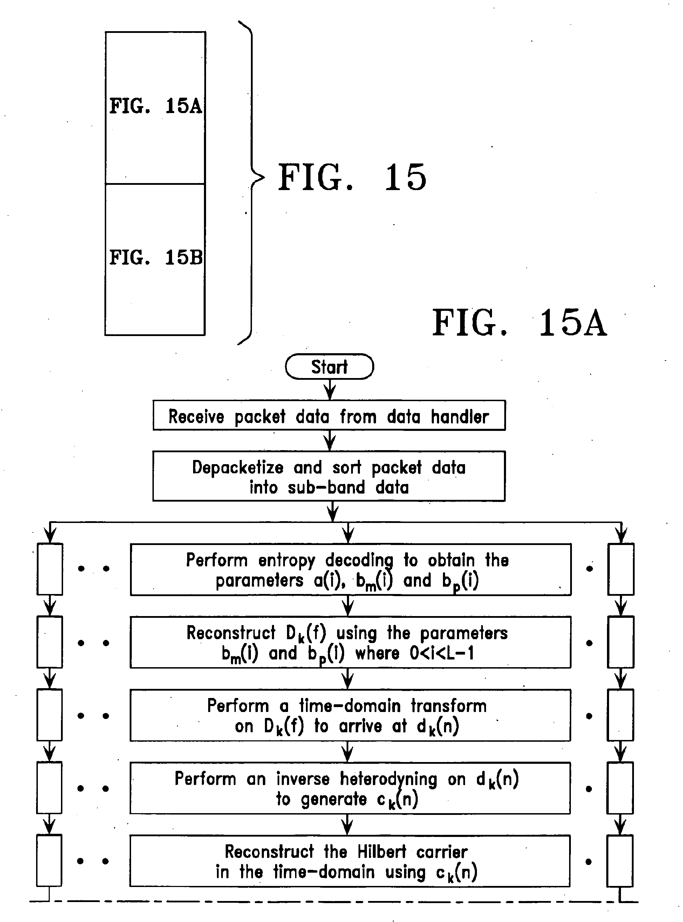

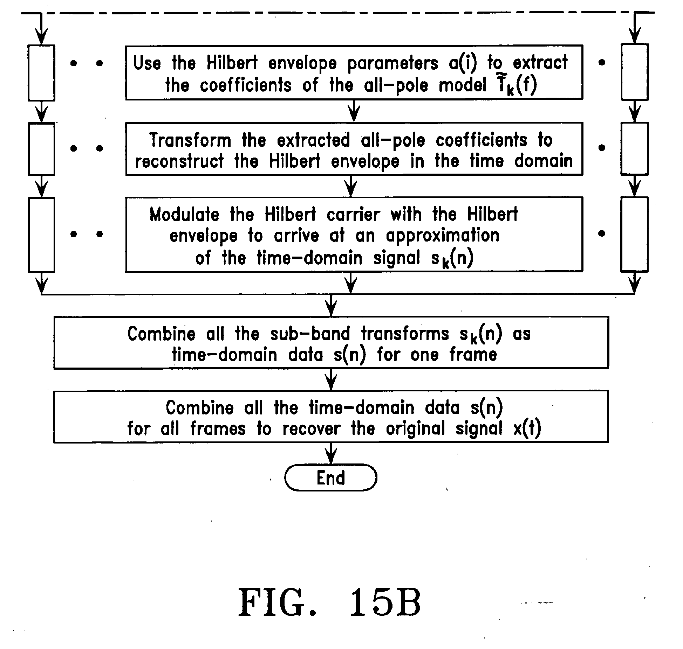

Data can be retrieved from the data handler 36 for decoding and reconstruction. Referring to FIG. 2, during decoding, the packetized data from the data handler 36 are sent to the depacketizer 44 and then undergo the decoding process by the decoder 42. The decoding process is substantially the reverse of the encoding process as described above. For the sake of clarity, the decoding process is not elaborated but summarized in the flow chart of FIG. 15.

During transmission, if data in few of the M frequency sub-bands are corrupted, the quality of the reconstructed signal should not be affected much. This is because the relatively long frame 46 (FIG. 4) can capture sufficient spectral information to compensate for the minor data imperfection.

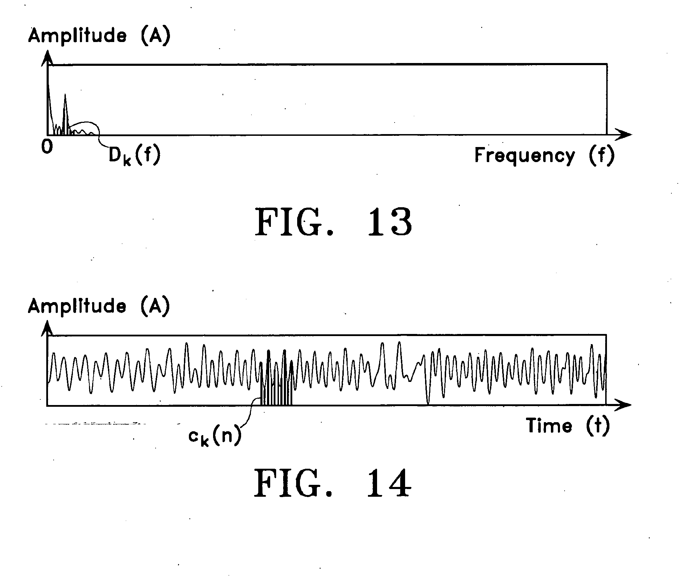

An exemplary reconstructed frequency-domain transform $D_k(f)$ of the demodulated Hilbert carrier $d_k(t)$ are respectively shown in FIGs. 13 and 14.

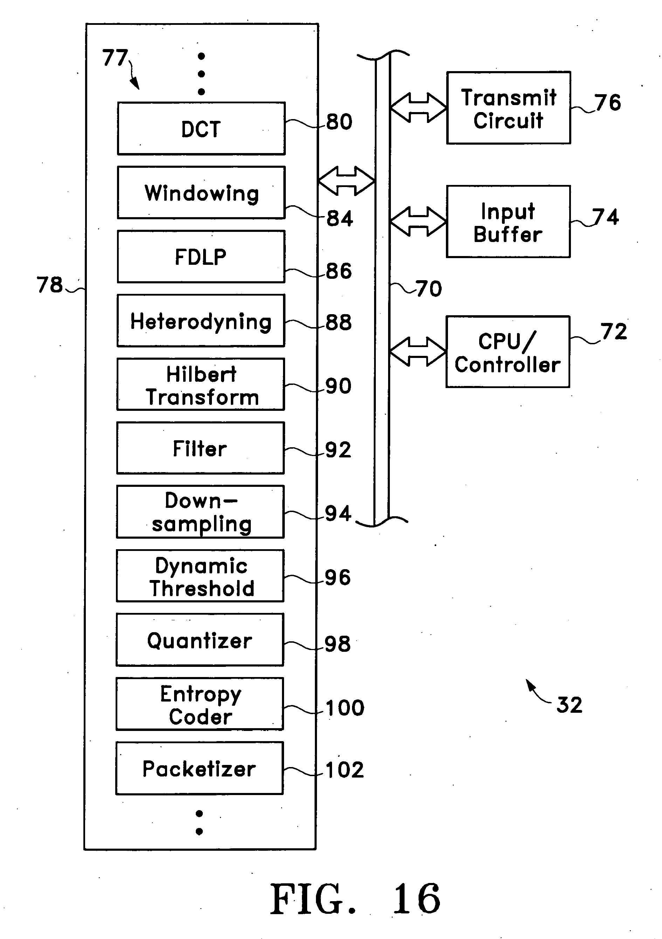

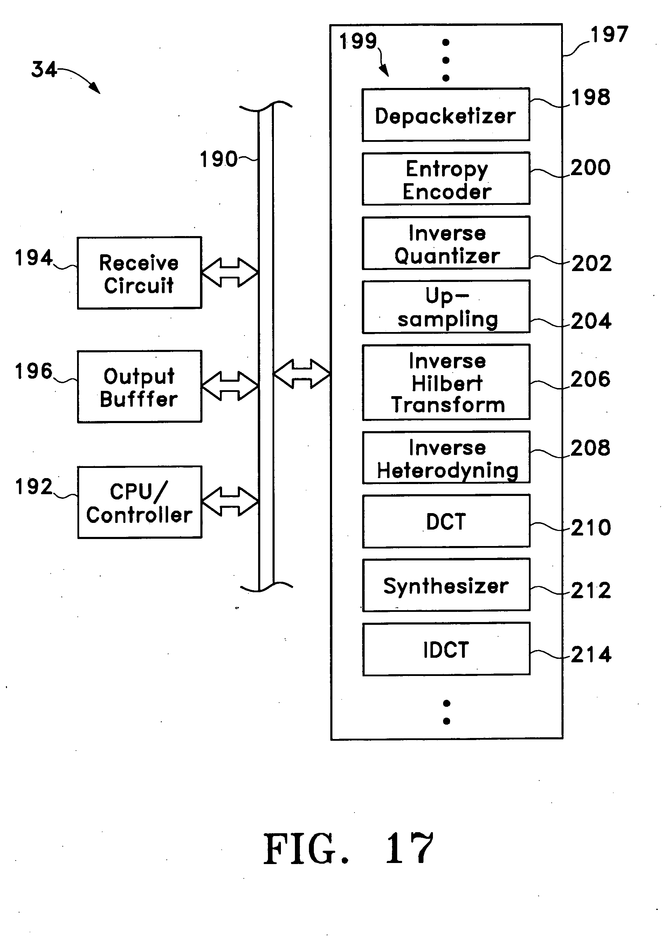

FIGs. 16 and 17 are schematic drawings which illustrate exemplary hardware implementations of the encoding section 32 and the decoding section 34, respectively, of FIG. 2.

Reference is first directed to the encoding section 32 of FIG. 16. The encoding section 32 can be built or incorporated in various forms, such as a computer, a mobile musical player, a personal digital assistant (PDA), a wireless telephone and so forth, to name just a few.

The encoding section 32 comprises a central data bus 70 linking several circuits together. The circuits include a central processing unit (CPU) or a controller 72, an input buffer 74, and a memory unit 78. In this embodiment, a transmit circuit 76 is also included.

If the encoding section 32 is part of a wireless device, the transmit circuit 74 can be connected to a radio frequency (RF) circuit but is not shown in the drawing. The transmit circuit 76 processes and buffers the data from the data bus 70 before sending out of the circuit section 32. The CPU/controller 72 performs the function of data management of the data bus 70 and further the function of general data processing, including executing the instructional contents of the memory unit 78.

Instead of separately disposed as shown in FIG. 12, as an alternative, the transmit circuit 76 can be parts of the CPU/controller 72.

The input buffer 74 can be tied to other devices (not shown) such as a microphone or an output of a recorder.

The memory unit 78 includes a set of computer-readable instructions generally signified by the reference numeral 77. In this specification and appended claims, the terms "computer-readable instructions" and "computer-readable program code" are used interchangeably. In this embodiment, the instructions include, among other things, portions such as the DCT function 80, the windowing function 84, the FDLP function 86, the heterodyning function 88, the Hilbert transform function 90, the filtering function 92, the down-sampling function 94, the dynamic thresholding function 96, the quantizer function 98, the entropy coding function 100 and the packetizer 102.

The various functions have been described, e.g., in the description of the encoding process shown in FIG. 3, and are not further repeated.

Reference is now directed to the decoding section 34 of FIG. 17. Again, the decoding section 34 can be built in or incorporated in various forms as the encoding section 32 described above.

The decoding section 34 also has a central bus 190 connected to various circuits together, such as a CPU/controller 192, an output buffer 196, and a memory unit 197. Furthermore, a receive circuit 194 can also be included. Again, the receive circuit 194 can be connected to a RF circuit (not shown) if the decoding section 34 is part of a wireless device. The receive circuit 194 processes and buffers the data from the data bus 190 before sending into the circuit section 34. As an alternative, the receive circuit 194 can be parts of the CPU/controller 192, rather than separately disposed as shown. The CPU/controller 192 performs the function of data management of the data bus 190 and further the function of general data processing, including executing the instructional contents of the memory unit 197.

The output buffer 196 can be tied to other devices (not shown) such as a loudspeaker or the input of an amplifier.

The memory unit 197 includes a set of instructions generally signified by the reference numeral 199. In this embodiment, the instructions include, among other things, portions such as the depackertizer function 198, the entropy decoder function 200, the inverse quantizer function 202, the up-sampling function 204, the inverse Hilbert transform function 206, the inverse heterodyning function 208, the DCT function 210, the synthesis function 212, and the IDCT function 214.

The various functions have been described, e.g., in the description of the decoding process shown in FIG. 15, and again need not be further repeated.

It should be noted the encoding and decoding sections 32 and 34 are shown separately in FIGs. 16 and 17, respectively. In some applications, the two sections 32 and 34 are very often implemented together. For instance, in a communication device such as a telephone, both the encoding and decoding sections 32 and 34 need to be installed. As such, certain circuits or units can be commonly shared between the sections. For example, the CPU/controller 72 in the encoding section 32 of FIG. 16 can be the same as the CPU/controller 192 in the decoding section 34 of FIG. 17. Likewise, the central data bus 70 in FIG. 16 can be connected or the same as the central data bus 190 in FIG. 17. Furthermore, all the instructions 77 and 199 for the functions in both the encoding and decoding sections 32 and 34, respectively, can be pooled together and disposed in one memory unit, similar to the memory unit 78 of FIG. 16 or the memory unit 197 of FIG. 17.

In this embodiment, the memory unit 78 or 197 is a RAM (Random Access Memory) circuit. The exemplary instruction portions 80, 84, 86, 88, 90, 92, 94, 96, 98, 100, 102, 197, 198, 200, 202, 204, 206, 208, 210, 212 and 214 are software routines or modules. The memory unit 78 or 197 can be tied to another memory circuit (not shown) which can either be of the volatile or nonvolatile type. As an alternative, the memory unit 78 or 197 can be made of other circuit types, such as an EEPROM (Electrically Erasable Programmable Read Only Memory), an EPROM (Electrical Programmable Read Only Memory), a ROM (Read Only Memory), a magnetic disk, an optical disk, and others well known in the art.

Furthermore, the memory unit 78 or 197 can be an application specific integrated circuit (ASIC). That is, the instructions or codes 77 and 199 for the functions can be hard-wired or implemented by hardware, or a combination thereof. In addition, the instructions 77 and 199 for the functions need not be distinctly classified as hardware or software implemented. The instructions 77 and 199 surely can be implemented in a device as a combination of both software and hardware.

It should be further be noted that the encoding and decoding processes as described and shown in FIGs. 3 and 15 above can also be coded as computer-readable instructions or program code carried on any computer-readable medium known in the art. In this specification and the appended claims, the term "computer-readable medium" refers to any medium that participates in providing instructions to any processor, such as the CPU/controller 72 or 192 respectively shown and described in FIGs. 16 or 17, for execution. Such a medium can be of the storage type and may take the form of a volatile or non-volatile storage medium as also described previously, for example, in the description of the memory unit 78 and 197 in FIGs. 16 and 17, respectively. Such a medium can also be of the transmission type and may include a coaxial cable, a copper wire, an optical cable, and the air interface carrying acoustic, electromagnetic or optical waves capable of carrying signals readable by machines or computers. In this specification and the appended claims, signal-carrying waves, unless specifically identified, are collectively called medium waves which include optical, electromagnetic, and acoustic waves.

Finally, other changes are possible within the scope of the invention. In the exemplary embodiment as described, only processing of audio signals is depicted. However, it should be noted that the invention is not so limited. Processing of other types of signals, such as ultra sound signals, are also possible. It also should be noted that the invention can very well be used in a broadcast setting, i.e., signals from one encoder can be sent to a plurality of decoders. Furthermore, the exemplary embodiment as described need not be confined to be used in wireless applications. For instance, a conventional wireline telephone certainly can be installed with the exemplary encoder and decoder as described. In addition, in describing the embodiment, the Levinson-Durbin algorithm is used, other algorithms known in the art for estimating the predictive filter parameters can also be employed. Additionally, any logical blocks, circuits, and algorithm steps described in connection with the embodiment can be implemented in hardware, software, firmware, or combinations thereof. It will be understood by those skilled in the art that theses and other changes in form and detail may be made therein without departing from the scope of the invention.

**Claims**

1. A method for encoding a time-varying signal, comprising:

   partitioning said time-varying signal into a plurality of sub-band signals;
   determining the envelope and carrier portions of each of said sub-band signals;
   frequency-shifting said carrier portion towards the baseband frequency of said time-varying signal as a down-shifted carrier signal;
   selecting values of said down-shifted carrier signal, wherein the values of said down-shifted carrier signal are subject to adaptive threshold filtering; and
   including said selected values as encoded data of said time-varying signal.

2. The method as in claim 1 further comprising converting said time-varying signal as a discrete signal prior to encoding.

3. The method as in claim 1 further comprising transforming said time-varying signal into a frequency-domain transform, wherein said plurality of sub-band signals being selected from said frequency-domain transform of said time-varying signal.

4. The method as in claim 3 wherein said envelope and carrier portions are frequency-domain signals, said method further comprising transforming said carrier portion of said frequency-domain signals into a time-domain transform prior to frequency-shifting said carrier portion towards the baseband frequency.

5. A method for decoding a time-varying signal, comprising:

   providing a plurality sets of values corresponding to a plurality of sub-bands of said time-varying signal, said sets of values comprising envelope and carrier information of said time-varying signal;
   identifying said carrier information from said plurality sets of values as a plurality of carrier signals corresponding to said plurality of sub-bands;
   frequency-shifting each or said plurality of carrier signals away from the baseband frequency of said time-varying signal as an up-shifted carrier signal; and
including said up-shifted carrier signal as decoded data of said time-varying signal.

6. The method as in claim 5 further comprising inverse-heterodyning each of said plurality of carrier signals as an up-shifted carrier signal.

7. The method as in claim 6 further comprising identifying said envelope information from said plurality sets of values as a plurality of envelope signals corresponding to said plurality of sub-bands, and thereafter modulating said plurality of carrier signals by said plurality of envelope signals as a reconstructed version of said time-varying signal.

8. An apparatus for encoding a time-varying signal, comprising:

   means for partitioning said time-varying signal into a plurality of sub-band signals;
   means for determining the envelope and carrier portions of each of said sub-band signals;
   means for frequency-shifting said carrier portion towards the baseband frequency of said time-varying signal as a down-shifted carrier signal;
   means for selecting values of said down-shifted carrier signal, wherein the values of said down-shifted carrier signal are subject to adaptive threshold filtering; and
   means for including said selected values as encoded data of said time-varying signal.

9. The apparatus as in claim 8 further comprising means for converting said time-varying signal as a discrete signal prior to encoding.

10. The apparatus as in claim 8 further comprising means for transforming said time-varying signal into a frequency-domain transform, wherein said plurality of sub-band signals being selected from said frequency-domain transform of said time-varying signal.

11. An apparatus for decoding a time-varying signal, comprising:

   means for providing a plurality sets of values corresponding to a plurality of sub-bands of said time-varying signal, said sets of values comprising envelope and carrier information of said time-varying signal;
   means for identifying said carrier information from said plurality sets of values as a plurality of carrier signals corresponding to said plurality of sub-bands;
   means for frequency-shifting each of said plurality of carrier signals away from the baseband frequency of said time-varying signal as an up-shifted carrier signal; and
   means for including said up-shifted carrier signal as decoded data of said time-varying signal.

12. The apparatus of claim 8,
   wherein the means for partitioning, the means for determining, the means for frequency-shifting, and the means for selectively selecting are employed in an encoder; and
   wherein the means for including is a data packetizer connected to said encoder for packetizing said selected values as part of encoded data of said time-varying signal.

13. The apparatus as in claim 12 further comprising a transmit circuit connected to said data packetizer for sending said encoded data through a communication channel.

14. The apparatus of claim 11, wherein:

   the means for providing, the means for identifying, the means for frequency-shifting, are employed in a data depacketizer, and
   the means for including is a decoder connected to said data depacketizer, said decoder being configured to transform said set of values into time-domain values.

15. A computer program product comprising instructions which, when run on a computer, will cause said computer to perform the steps of any of claims 1 to 7.

**EP 2 005 423 B1**

**Patentansprüche**

1. Ein Verfahren zum Codieren eines zeitvariierenden Signals, wobei das Verfahren Folgendes aufweist:

   Partitionieren des zeitvariierenden Signals in einer Vielzahl von Unterbandsignalen;
   Bestimmen der Einhüllenden- und Trägerteile für jedes der Unterbandsignale;
   Frequenzverschieben des Trägerteils zu der Basisbandfrequenz des zeitvariierenden Signals als ein abwärtsverschobenes Trägersignal;
   Auswählen von Werten des abwärtsverschobenen Trägersignals, wobei die Werte des abwärtsverschobenen Trägersignals einer adaptiven Schwellenfilterung unterliegen; und
   Einfügen der ausgewählten Werte als codierte Daten des zeitvariierenden Signals.

2. Verfahren nach Anspruch 1, das weiterhin das Konvertieren des zeitvariierenden Signals als ein diskretes Signal vor dem Codieren aufweist.

3. Verfahren nach Anspruch 1, das weiterhin das Transformieren des zeitvariierenden Signals in eine Frequenz-Domänen-Transformation aufweist, wobei die Vielzahl von Unterbandsignalen von der Frequenz-Domain-Transformation des zeitvariierenden Signals ausgewählt werden.

4. Verfahren nach Anspruch 3, wobei die Einhüllenden- und Trägerteile Frequenz-Domänen-Signale sind, wobei das Verfahren weiterhin das Transformieren des Trägerteils von den Frequenz-Domänen-Signalen in eine Zeit-Domänen-Transformation aufweist, und zwar vor dem Frequenzverschieben des Trägerteils zur Basisbandfrequenz.

5. Ein Verfahren zum Decodieren eines zeitvariierenden Signals, wobei das Verfahren Folgendes aufweist:

   Vorsehen einer Vielzahl von Sätzen von Werten entsprechend einer Vielzahl von Unterbändern des zeitvariierenden Signals, wobei die Sätze von Werten Einhüllenden- und Trägerinformationen des zeitvariierenden Signals aufweisen;
   Identifizieren der Trägerinformationen von der Vielzahl von Sätzen von Werten als eine Vielzahl von Trägersignalen, entsprechend der Vielzahl von Unterbändern;
   Frequenzverschieben von jedem der Vielzahl von Trägersignalen weg von der Basisbandfrequenz des zeitvariierenden Signals, als ein aufwärtsverschobenes Trägersignal; und
   Einfügen des aufwärtsverschobenen Trägersignals, als decodierte Daten des zeitvariierenden Signals.

6. Verfahren nach Anspruch 5, das weiterhin das inverse Überlagern von jedem von der Vielzahl von Trägersignalen als ein aufwärtsverschobenes Trägersignal aufweist:

7. Verfahren nach Anspruch 6, das weiterhin das Identifizieren der einhüllenden Information von der Vielzahl von Sätzen von Werten aus einer Vielzahl von einhüllenden Signalen entsprechend der Vielzahl von Unterbändern aufweist, und danach Modulieren der Vielzahl von Trägersignalen durch die Vielzahl von einhüllenden Signalen als eine rekonstruierte Version des zeitvariierenden Signals.

8. Eine Vorrichtung zum Codieren eines zeitvariierenden Signals, die Folgendes aufweist:

   Mittel zum Partitionieren des zeitvariierenden Signals in eine Vielzahl von Unterbandsignalen;
   Mittel zum Bestimmen der Einhüllenden- und Trägerteile für jedes der Unterbandsignale;
   Mittel zum Frequenzverschieben des Trägerteils zu der Basisbandfrequenz des zeitvariierenden Signals als ein abwärtsverschobenes Trägersignal;
   Mittel zum Auswählen von Werten des abwärtsverschobenen Trägersignals, wobei die Werte des abwärtsverschobenen Trägersignals einer adaptiven Schwellenfilterung unterliegen; und
   Mittel zum Einfügen der ausgewählten Werte als codierte Daten des zeitvariierenden Signals.

9. Vorrichtung nach Anspruch 8, die weiterhin Mittel zum Konvertieren des zeitvariierenden Signals als ein diskretes Signal vor dem Codieren aufweist.

10. Vorrichtung nach Anspruch 8, die weiterhin Mittel zum Transformieren des zeitvariierenden Signals in eine Frequenz-Domänen-Transformation aufweist, wobei die Vielzahl von Unterbandsignalen von der Frequenz-Domain-Transformation des zeitvariierenden Signals ausgewählt werden.

**11.** Eine Vorrichtung zum Decodieren eines zeitvariierenden Signals die Folgendes aufweist:

Mittel zum Vorsehen einer Vielzahl von Sätzen von Werten entsprechend einer Vielzahl von Unterbändern des zeitvariierenden Signals, wobei die Sätze von Werten, Einhüllenden- und Trägerinformationen des zeitvariierenden Signals aufweisen;
Mittel zum Identifizieren der Trägerinformationen von der Vielzahl von Sätzen von Werten als eine Vielzahl von Trägersignalen entsprechend der Vielzahl von Unterbändern;
Mittel zum Frequenzverschieben von jedem von der Vielzahl von Trägersignalen weg von der Basisbandfrequenz des zeitvariierenden Signals als ein aufwärtsverschobenes Trägersignal; und
Mittel zum Einfügen des aufwärtsverschobenen Trägersignals als decodierte Daten des zeitvariierenden Signals.

**12.** Vorrichtung nach Anspruch 8, wobei die Mittel zum Partitionieren, die Mittel zum Bestimmen, die Mittel zum Frequenzverschieben und die Mittel zum Auswählen in einem Codierer eingebaut sind; und wobei die Mittel zum Einfügen ein Datenpaketisierer sind verbunden mit dem Codierer zum Paketisieren der ausgewählten Werte als Teil der codierten Daten des zeitvariierenden Signals.

**13.** Vorrichtung nach Anspruch 12, das weiterhin einen Sendeschaltkreis verbunden mit den Datenpaketisierer zum Senden der codierten Daten über einen Kommunikationskanal aufweist.

**14.** Vorrichtung nach Anspruch 11, wobei:

die Mittel zum Vorsehen, die Mittel zum Identifizieren, die Mittel zum Frequenzverschieben in einem Datenentpaketisierer eingebaut sind, und die Mittel zum Einfügen ein Decodierer ist, verbunden mit dem Entpaketisierer, wobei der Decodierer konfiguriert ist zum Transformieren des Satzes von Werten in Zeitdomänenwerte.

**15.** Ein Computerprogrammprodukt, das Instruktionen aufweist, die, wenn ausgeführt auf einem Computer, den Computer verursachen, die Schritte nach einem der Ansprüche 1 bis 7 durchzuführen.

**Revendications**

**1.** Procédé pour coder un signal variable dans le temps, comprenant les étapes suivantes :

diviser le signal variable dans le temps en une pluralité de signaux de sous-bandes ;
déterminer l'enveloppe et des parties de porteuse de chacun des signaux de sous-bandes ;
décaler en fréquence la partie de porteuse vers la fréquence de bande de base du signal variable dans le temps pour obtenir un signal de porteuse décalé vers le bas ;
sélectionner des valeurs du signal de porteuse décalé vers le bas, les valeurs du signal de porteuse décalé vers le bas étant soumises à un filtrage à seuil adaptatif ; et
inclure les valeurs sélectionnées en tant que données codées du signal variable dans le temps.

**2.** Procédé selon la revendication 1, comprenant en outre la conversion du signal variable dans le temps en un signal discret avant le codage.

**3.** Procédé selon la revendication 1, comprenant en outre la transformation du signal variable dans le temps en une transformée dans le domaine fréquentiel, la pluralité de signaux de sous-bandes étant sélectionnée à partir de la transformée dans le domaine fréquentiel du signal variable dans le temps.

**4.** Procédé selon la revendication 3, dans lequel l'enveloppe et les parties de porteuse sont des signaux dans le domaine fréquentiel, le procédé comprenant en outre la transformation de la partie de porteuse des signaux dans le domaine fréquentiel en une transformée dans le domaine temporel avant de décaler en fréquence la partie de porteuse vers la fréquence de bande de base.

**5.** Procédé pour décoder un signal variable dans le temps, comprenant les étapes suivantes :

fournir une pluralité d'ensemble de valeurs correspondant à une pluralité de sous-bandes du signal variable dans le temps, les ensembles de valeurs comprenant des informations d'enveloppe et de porteuse du signal

**14**

variable dans le temps ;

identifier les informations de porteuse dans la pluralité d'ensembles de valeurs en tant que pluralité de signaux de porteuse correspondant à la pluralité de sous-bandes ;

décaler en fréquence chaque signal de la pluralité de signaux de porteuse en s'éloignant de la fréquence de bande de base du signal variable dans le temps pour obtenir un signal de porteuse décalé vers le haut ; et

inclure le signal de porteuse décalé vers le haut en tant que données décodées du signal variable dans le temps.

6. Procédé selon la revendication 5, comprenant en outre une transformation hétérodyne inverse de chacun de la pluralité de signaux de porteuse en un signal de porteuse décalé vers le haut.

7. Procédé selon la revendication 6, comprenant en outre l'identification des informations d'enveloppe dans la pluralité d'ensembles de valeurs en tant que pluralité de signaux d'enveloppe correspondant à la pluralité de sous-bandes, et ensuite la modulation de la pluralité de signaux de porteuse par la pluralité de signaux d'enveloppe en tant que version reconstruite du signal variable dans le temps.

8. Dispositif pour coder un signal variable dans le temps, comprenant :

des moyens pour diviser le signal variable dans le temps en une pluralité de signaux de sous-bandes ;

des moyens pour déterminer l'enveloppe et des parties de porteuse de chacun des signaux de sous-bandes ;

des moyens pour décaler en fréquence la partie de porteuse vers la fréquence de bande de base du signal variable dans le temps pour obtenir un signal de porteuse décalé vers le bas ;

des moyens pour sélectionner des valeurs du signal de porteuse décalé vers le bas, les valeurs du signal de porteuse décalé vers le bas étant soumises à un filtrage à seuil adaptatif ; et

des moyens pour inclure les valeurs sélectionnées en tant que données codées du signal variable dans le temps.

9. Dispositif selon la revendication 8, comprenant en outre des moyens pour convertir le signal variable dans le temps en un signal discret avant le codage.

10. Dispositif selon la revendication 8, comprenant en outre des moyens pour transformer le signal variable dans le temps en une transformée dans le domaine fréquentiel, la pluralité de signaux de sous-bande étant sélectionnée à partir de la transformée dans le domaine fréquentiel du signal variable dans le temps.

11. Dispositif pour décoder un signal variable dans le temps, comprenant :

des moyens pour fournir une pluralité d'ensembles de valeurs correspondant à une pluralité de sous-bandes du signal variable dans le temps, les ensembles de valeurs comprenant des informations d'enveloppe et de porteuse du signal variable dans le temps ;

des moyens pour identifier les informations de porteuse dans la pluralité d'ensembles de valeurs en tant que pluralité de signaux de porteuse correspondant à la pluralité de sous-bandes ;

des moyens pour décaler en fréquence chaque signal de la pluralité de signaux de porteuse en s'éloignant de la fréquence de bande de base du signal variable dans le temps pour obtenir un signal de porteuse décalé vers le haut ; et

des moyens pour inclure le signal de porteuse décalé vers le haut en tant que données décodées du signal variable dans le temps.

12. Dispositif selon la revendication 8,

dans lequel les moyens pour diviser, les moyens pour déterminer, les moyens pour décaler en fréquence, et les moyens pour sélectionner sélectivement sont utilisés dans un codeur ; et

dans lequel les moyens pour inclure sont un empaqueteur de données connecté au codeur pour empaqueter les valeurs sélectionnées en tant que partie de données codées du signal variable dans le temps.

13. Dispositif selon la revendication 12, comprenant en outre un circuit d'émission connecté à l'empaqueteur de données pour envoyer lesdites données codées par l'intermédiaire d'un canal de communication.

14. Dispositif selon la revendication 11, dans lequel :

les moyens pour fournir, les moyens pour identifier et les moyens pour décaler en fréquence, sont employés dans un extracteur de données, et

les moyens pour inclure sont un décodeur connecté à l'extracteur de données, le décodeur étant agencé pour transformer l'ensemble de valeurs en valeurs dans le domaine temporel.

15. Produit programme d'ordinateur comprenant des instructions qui, lorsqu'elles sont exécutées sur un ordinateur, vont amener l'ordinateur à réaliser les étapes de l'une quelconque des revendications 1 à 7.

FIG. 1

FIG. 2

FIG. 3A

FIG. 3B

} FIG. 3

FIG. 3A

( Start )

S1 — | Sample the time-varying signal x(t) into a discrete signal x(n) |

S2 — | Partition discrete signal x(n) into frames of signal s(n) with each frame at a predetermined duration |

S3 — | Transform the discrete signal s(n) via DCT into a frequency transform T(f) |

S4 — | Separate the N DCT coefficients of the frequency transform T(f) into M sub-bands $T_k(f)$ which fit within M Bark-scaled frequency windows |

S5k — | Apply FDLP to represent the Hilbert envelope of $T_k(f)$ as $\tilde{T}_k(f)$ by an all-pole model |

S5

S6k — | Quantize the all-pole model as represented by $\tilde{T}_k(f)$ as a(i), where $0 < i < K-1$ |

S6

S7k — | Perform a time-domain transform of $\tilde{T}_k(f)$ to arrive at $\tilde{s}_k(n)$ |

S7

Determine the carrier signal $c_k(n)$ via dividing $s_k(n)$ by $\tilde{s}_k(n)$ — S8, S8k

Perform a Hilbert transform on $c_k(n)$ to arrive at an imaginary part $\hat{c}_k(n)$ — S9, S9k

Generate an analytic signal $z_k(n)$ by summing $c_k(n)$ and $j\hat{c}_k(n)$ — S10, S10k

Perform a scalar multiplication (i.e., heterodyning) $z_k(n).c_k(n)$ — S11, S11k

Lowpass filter the result of the scalar multiplication to gererate a down-shifted Hilbert carrier $d_k(n)$ — S12, S12k

Perform a frequency-domain transform on $d_k(n)$ to arrive at $D_k(f)$ — S13, S13k

Select components of $D_k(f)$ by applying dynamic thresholds — S14, S14k

Quantize the selected components of $D_k(f)$ as $b_m(i)$ and $b_p(i)$, where $0 < i < L-1$ — S15, S15k

Code $a(i)$, $b_m(i)$ and $b_p(i)$ using an entropy coding scheme — S16, S16k

Packetize all processed $a(i)$, $b_m(i)$ and $b_p(i)$ in all sub-bands as packet data — S17

Send packet data to data handler — S18

End

FIG. 3B

FIG. 4

FIG. 5

FIG. 6

FIG. 7

FIG. 8

FIG. 9

FIG. 10

Amplitude
(A)

50

Amplitude
(A)

Frequency (f)

## FIG. 11

FDLP

$$T_k(f) \rightarrow \quad H(z) = \cfrac{1}{1 + \sum\limits_{k=0}^{K-1} a(i)\, z^{-k}} \rightarrow a(i)$$

## FIG. 12

Amplitude (A)

0     $D_k(f)$              Frequency (f)

# FIG. 13

Amplitude (A)

$c_k(n)$             Time (t)

# FIG. 14

FIG. 15A

FIG. 15B

} FIG. 15

FIG. 15A

( Start )

Receive packet data from data handler

Depacketize and sort packet data
into sub-band data

Perform entropy decoding to obtain the
parameters $a(i)$, $b_m(i)$ and $b_p(i)$

Reconstruct $D_k(f)$ using the parameters
$b_m(i)$ and $b_p(i)$ where $0<i<L-1$

Perform a time-domain transform
on $D_k(f)$ to arrive at $d_k(n)$

Perform an inverse heterodyning on $d_k(n)$
to generate $c_k(n)$

Reconstruct the Hilbert carrier
in the time-domain using $c_k(n)$

25

Use the Hilbert envelope parameters a(i) to extract the coefficients of the all-pole model $\tilde{T}_k(f)$

Transform the extracted all-pole coefficients to reconstruct the Hilbert envelope in the time domain

Modulate the Hilbert carrier with the Hilbert envelope to arrive at an approximation of the time-domain signal $s_k(n)$

Combine all the sub-band transforms $s_k(n)$ as time-domain data s(n) for one frame

Combine all the time-domain data s(n) for all frames to recover the original signal x(t)

End

FIG. 15B

FIG. 16

34

199 · · · 197

Depacketizer — 198

Entropy
Encoder — 200

Inverse
Quantizer — 202

Up-
sampling — 204

Inverse
Hilbert
Transform — 206

Inverse
Heterodyning — 208

DCT — 210

Synthesizer — 212

IDCT — 214

190

194 — Receive
Circuit

196 — Output
Bufffer

192 — CPU/
Controller

# FIG. 17

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

## Patent documents cited in the description

- US 79104206 P
- US 583537 A
- WO 2005096274 A

## Non-patent literature cited in the description

- **RABINER ; SCHAFER.** Digital Processing of Speech Signals. Prentice Hall, September 1978
- **DELLER ; PROAKIS ; HANSEN.** Discrete-Time Processing of Speech Signals. Wiley-IEEE Press, September 1999
- **SCHIMMEL S et al.** Coherent Envelope Detection for Modulation Filtering of Speech. *ACOUSTICS, SPEECH, AND SIGNAL PROCESSING, 2005. PROCEEDINGS. (ICASSP '05). IEEE INTERNATIONAL CONFERENCE ON PHILADELPHIA PENNSYLVANIA,* 18 March 2005, ISBN 0-7803-8874-7, 221-224
- **ALAN V. OPPENHEIM ; RONALD W. SCHAFER ; JOHN R. BUCK.** Discrete-Time Signal Processing. Prentice Hall